# EUROPEAN PATENT APPLICATION

(11) **EP 2 824 711 A2**
(43) Date of publication of application: **14.01.2015**
(21) Application number: 14176590.9
(22) Date of filing: 10.07.2014
(51) Int. Cl.: H01L 29/78, H01L 29/778, H01L 21/336, H01L 29/417, H01L 29/06, H01L 21/268, H01L 29/08, H01L 29/20

(54) **Vertical transistors having p-type gallium nitride current barrier layers and methods of fabricating the same**

(30) Priority: 11.07.2013 KR 20130081622
(71) Applicant: Seoul Semiconductor Co., Ltd., Ansan-si 425-090 (KR)
(72) Inventor: Motonobu, Takeya, 425-090 Ansan-si (KR); Lee, Kwan Hyun, 425-851 Ansan-si (KR); Jeong, Young Do, 425-090 Ansan-si (KR)
(74) Representative: Stolmár & Partner

(57) **Abstract**

A vertical transistor includes a drain electrode (106) disposed on a first region of a substrate (102), a drift layer (108) disposed on a second region of the substrate spaced apart from the first region, and P-type gallium nitride current barrier layers (110) disposed on the drift layer and comprising a current aperture (109) disposed between current barrier layers. A channel layer (112) is disposed on the drift layer and the current barrier layers. A semiconductor layer (114) is disposed on the channel layer and configured to induce formation of a two-dimension electron gas layer (113) adjacent to a top surface thereof. Metal contact plugs (124) are disposed in the channel layer and contact the current barrier layers. A source electrode (116) is disposed on the contact plugs and the channel layer. A gate insulation layer (118) and a gate electrode (120) are sequentially disposed on a top surface of the semiconductor layer opposite to the channel layer.

## Description

### CROSS-REFERENCE TO RELATED APPLICATION

The present application claims priority from and the benefit of Korean Patent Application No. 10-2013-0081622, filed on July 11, 2013, which is hereby incorporated by reference for all purposes as if fully set forth herein.

### BACKGROUND

### FIELD

Exemplary embodiments of the present disclosure relate to transistors and methods of fabricating the same and, more particularly, to vertical transistors having p-type gallium nitride current barrier layers and methods of fabricating the same.

### DISCUSSION OF THE BACKGROUND

In the electronics industry, high voltage transistors operating at a high speed are increasingly in demand with the development of information and communication techniques. In response to such a demand, gallium nitride (GaN) transistors have been proposed. GaN transistors may exhibit a relatively fast switching characteristic and a relatively high breakdown voltage characteristic as compared with conventional silicon transistors. Thus, the GaN transistors may be attractive as candidates for improving the performance of communication systems. Particularly, high electron mobility transistors (HEMTs) fabricated using a gallium nitride (GaN) material may operate using a two-dimension electron gas (2DEG) generated at an interface in a heterogeneous material. Thus, electron mobility of the HEMTs may be improved to allow the HEMTs to operate at a high speed.

GaN transistors may be fabricated to have a planar-type configuration. In such a case, there may be a limitation in improving the carrier mobility, because an electric field at a channel surface may disturb movement of the carriers. Further, when the planar-type GaN transistors operate, an electric field may be concentrated at corners of gate electrodes of the planar-type GaN transistors. This may lead to degradation of the breakdown voltage characteristic of the planar-type GaN transistors.

Recently, vertical GaN transistors have been proposed to solve the above disadvantages. For example, current aperture vertical electron transistors (CAVETs) are taught in U.S. patent publication No. US 2012/0319127 A1 to Chowdhury et al.*,* entitled "Current Aperture Vertical Electron Transistors with Ammonia Molecular Beam Epitaxy Grown P-type Gallium Nitride as a Current Blocking Layer". According to U.S. Patent Publication No. 2012/0319127 A1, a source electrode and a drain electrode are disposed to vertically face each other, and a P-type gallium nitride (P-GaN) layer acting as a current barrier layer is disposed between the source and drain electrodes. Accordingly, a channel current flows in a vertical direction from the drain electrode toward the source electrode through an aperture provided by the P-type gallium nitride (P-GaN) layer.

The P-type gallium nitride (P-GaN) layer acting as a current barrier layer may be formed by doping a gallium nitride layer with magnesium ions while the gallium nitride layer is grown. In such a case, all of the magnesium ions used as dopants may not be substituted for gallium atoms in the gallium nitride layer. Thus, the remaining magnesium ions may be combined with hydrogen ions generated by thermal decomposition of ammonia (NH₃) gas used as a source material of nitrogen to form a magnesium hydride (Mg-H) compound material. If the magnesium hydride (Mg-H) compound material exists in the P-type gallium nitride (P-GaN) layer, electrical characteristics of the GaN transistors may be degraded. For example, the magnesium hydride (Mg-H) compound material may disturb activation of the P-type gallium nitride (P-GaN) layer to degrade the function of the P-type gallium nitride (P-GaN) layer acting as a current barrier layer.

The above information disclosed in this Background section is only for enhancement of understanding of the background of the disclosure and therefore it may contain information that does not form any part of the prior art nor what the prior art may suggest to a person of ordinary skill in the art.

### SUMMARY

Exemplary embodiments of the present disclosure provide vertical transistors having p-type gallium nitride current barrier layers and methods of fabricating the same.

Additional features of the disclosure will be set forth in the description which follows, and in part will be apparent from the description, or may be learned by practice of the disclosure.

An exemplary embodiment discloses a vertical transistor including a drain electrode on a substrate, a drift layer on the substrate, and P-type gallium nitride current barrier layers disposed on the drift layer to define a current aperture therebetween. The current aperture provides a path through which carriers vertically moves. A channel layer is disposed on the drift layer and the P-type gallium nitride current barrier layers. The channel layer has a two-dimension electron gas layer adjacent to a top surface thereof. A semiconductor layer is disposed on the channel layer to induce formation of the two-dimension electron gas layer. Metal contact plugs penetrate the channel layer to contact the P-type gallium nitride current barrier layers. A source electrode is disposed on the metal contact plugs and the channel layer. A gate insulation layer and a gate electrode are sequentially stacked on a top surface of the semiconductor layer opposite to the channel layer.

According to further exemplary embodiments, a vertical transistor includes a drift layer on a drain electrode, a P-type gallium nitride current barrier layer on the drift layer, a donor layer on the P-type gallium nitride current barrier layer, metal contact plugs penetrating the donor layer to contact the P-type gallium nitride current barrier layers, a source electrode on the metal contact plugs and the donor layer, a trench penetrating the donor layer and the P-type gallium nitride current barrier layer to reach the drift layer, and a gate insulation layer and a gate electrode sequentially stacked on an inner surface of the trench.

According to further exemplary embodiments, a vertical transistor includes a drain electrode and current blocking patterns disposed on the drain electrode to define an opening therebetween. The opening provides a current flow path. A low-resistance pattern is disposed on the drain electrode in the opening defined by the current blocking patterns. A drift layer is disposed to cover the low-resistance pattern and the current blocking patterns. P-type gallium nitride current barrier layers are disposed in the drift layer. Each of the P-type gallium nitride current barrier layers has a channel region adjacent to a top surface thereof. Donor layers are disposed on respective ones of the P-type gallium nitride current barrier layers. Metal contact plugs penetrate the donor layers to contact the P-type gallium nitride current barrier layers. A source electrode is disposed on the metal contact plugs and the donor layers. A gate insulation layer and a gate electrode are sequentially stacked on the drift layer between the P-type gallium nitride current barrier layers. The gate insulation layer and the gate electrode extend onto the channel regions of the P-type gallium nitride current barrier layers.

According to further exemplary embodiments, a method of fabricating a vertical transistor includes preparing a structure that includes a drain electrode, a drift layer on the drain electrode, P-type gallium nitride current barrier layers in the drift layer, and donor layers disposed on respective ones of the P-type gallium nitride current barrier layers. The donor layers are patterned to form holes exposing portions of the P-type gallium nitride current barrier layers. Hydrogen in the P-type gallium nitride current barrier layers are removed after forming the holes.

It is to be understood that both the foregoing general description and the following detailed description are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this specification, illustrate exemplary embodiments of the disclosure, and together with the description serve to explain the principles of the disclosure.
FIG. 1 is a plan view illustrating a vertical transistor having a P-type gallium nitride current barrier layer according to an exemplary embodiment of the present disclosure.
FIG. 2 is a cross-sectional view taken along a line II - II' of FIG. 1.
FIG. 3 is a plan view illustrating a vertical transistor having a P-type gallium nitride current barrier layer according to an exemplary embodiment of the present disclosure.
FIG. 4 is a plan view illustrating a vertical transistor having a P-type gallium nitride current barrier layer according to an exemplary embodiment of the present disclosure.
FIG. 5 is a cross-sectional view taken along a line V-V' of FIG. 4.
FIG. 6 is a plan view illustrating a vertical transistor having a P-type gallium nitride current barrier layer according to an exemplary embodiment of the present disclosure.
FIG. 7 is a plan view illustrating a vertical transistor having a P-type gallium nitride current barrier layer according to an exemplary embodiment of the present disclosure.
FIG. 8 is a cross-sectional view taken along a line VIII-VIII' of FIG. 7.
FIG. 9 is a plan view illustrating a vertical transistor having a P-type gallium nitride current barrier layer according to an exemplary embodiment of the present disclosure.
FIGS. 10 to 20 are cross-sectional views illustrating a method of fabricating a vertical transistor having a P-type gallium nitride current barrier layer according to an exemplary embodiment of the present disclosure.

### DETAILED DESCRIPTION OF THE ILLUSTRATED EMBODIMENTS

The disclosure is described more fully hereinafter with reference to the accompanying drawings, in which embodiments of the disclosure are shown. This disclosure may, however, be embodied in many different forms and should not be construed as limited to the embodiments set forth herein. Rather, these embodiments are provided so that this disclosure is thorough, and will fully convey the scope of the disclosure to those skilled in the art. In the drawings, the size and relative sizes of layers and regions may be exaggerated for clarity. Like reference numerals in the drawings denote like elements.

It will be understood that when an element or layer is referred to as being "on" or "connected to" another element or layer, it can be directly on or directly connected to the other element or layer, or intervening elements or layers may be present. In contrast, when an element is referred to as being "directly on" or "directly connected to" another element or layer, there are no intervening elements or layers present. It will be understood that for the purposes of this disclosure, "at least one of X, Y, and Z" can be construed as X only, Y only, Z only, or any combination of two or more items X, Y, and Z (e.g., XYZ, XYY, YZ, ZZ).

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

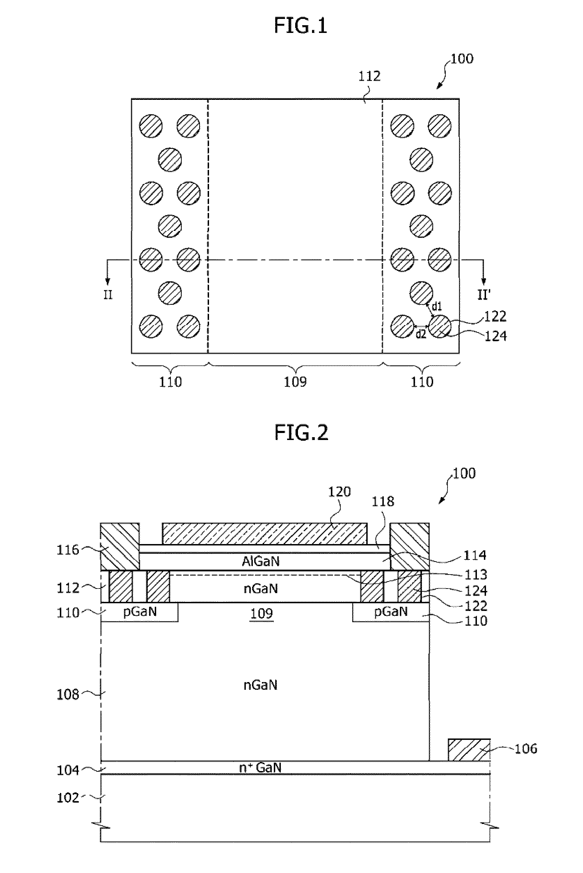

FIG. 1 is a plan view illustrating a vertical transistor 100 having a P-type gallium nitride current barrier layer according to an exemplary embodiment of the present disclosure, and FIG. 2 is a cross-sectional view taken along a line II - II' of FIG. 1. FIG. 1 corresponds to a plan view at a surface level of a channel layer 112 of FIG. 2. Referring to FIGS. 1 and 2, a gallium nitride (GaN) layer 104 heavily doped with N-type impurities is disposed on a substrate 102. A drift layer 108 is disposed on a first region of the N-type GaN layer 104. A drain electrode 106 is disposed on a second region of the N-type GaN layer 104. The drift layer 108 may be an N-type GaN layer having an impurity concentration lower than that of the N-type GaN layer 104. P-type GaN current barrier layers 110 are disposed on regions (edge portions) of the drift layer 108. As illustrated in FIG. 1, the P-type GaN current barrier layers 110 extend in one direction to have stripe shapes. Each of the P-type GaN current barrier layers 110 may be a GaN layer doped with magnesium ions corresponding to a P-type dopant. A current aperture 109 corresponding to a region between the P-type GaN current barrier layers 110 is disposed on the drift layer 108.

A channel layer 112 having a two-dimension electron gas layer 113 is disposed on the drift layer 108 and the P-type GaN current barrier layers 110. The two-dimension electron gas layer 113 is disposed to be adjacent to a surface of the channel layer 112 opposite to the drift layer 108. In an exemplary embodiment, the channel layer 112 may be an N-type GaN layer. A semiconductor layer 114 is disposed on the channel layer 112 to induce formation of the two-dimension electron gas layer 113. The semiconductor layer 114 may be an aluminum gallium nitride (AlGaN) layer. Metal contact plugs 124 vertically penetrate the channel layer 112 to directly contact each of the P-type GaN current barrier layers 110.

Each of the metal contact plugs 124 has a circular shape in a plan view, as illustrated in FIG. 1. That is, each of the metal contact plugs 124 fills a cylinder-shaped (circular) hole 122 penetrating the channel layer 112. Each of the metal contact plugs 124 includes a metal material exhibiting an ohmic contact property with respect to the P-type GaN current barrier layer 110. Distances D1 and D2 between the metal contact plugs 124 are less than or equal to 5 micrometers. Source electrode 116 is disposed on the metal contact plugs 124 and the channel layer 112. A gate insulation layer 118 is disposed on the semiconductor layer 114, and a gate electrode 120 is disposed on the gate insulation layer 118.

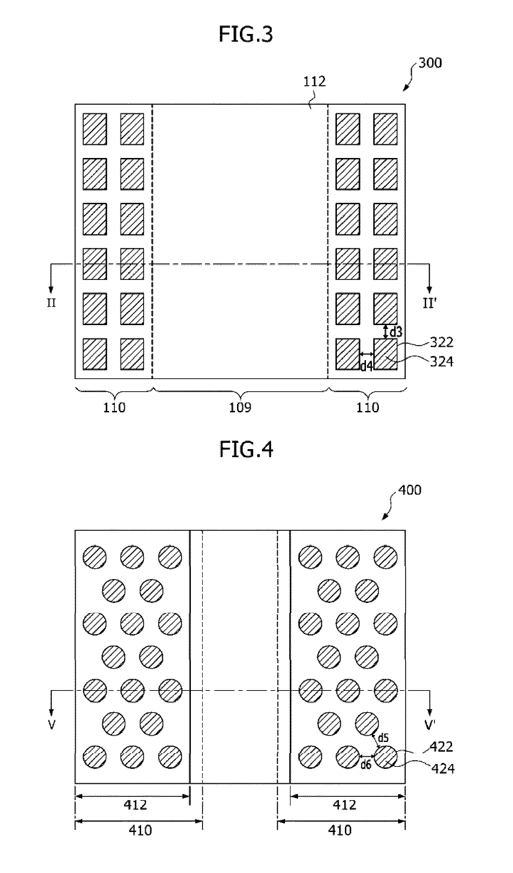

FIG. 3 is a plan view illustrating a vertical transistor 300 having a P-type gallium nitride current barrier layer according to an exemplary embodiment of the present disclosure. A cross-sectional view taken along a line II - II' of FIG. 3 is the same as the cross-sectional view of FIG. 2. In FIG. 3, the same reference numerals as used in FIGS. 1 and 2 denote the same elements as set forth with reference to FIGS. 1 and 2. Thus, detailed descriptions of the same elements as set forth with reference to FIGS. 1 and 2 will be omitted hereinafter to avoid a repeated description. Referring to FIG. 3, the vertical transistor 300 according to the present exemplary embodiment is different from the vertical transistor 100 of FIG. 1 in terms of a shape of metal contact plugs 324. Specifically, while each of the metal contact plugs 124 of the vertical transistor 100 has a circular shape in a plan view, each of the metal contact plugs 324 of the vertical transistor 300 has a rectangular shape in a plan view. That is, each of the metal contact plugs 324 fill a tetragon-shaped (rectangular) hole 322 penetrating the channel layer 112. Distances D3 and D4 between the metal contact plugs 324 are less than or equal to 5 micrometers.

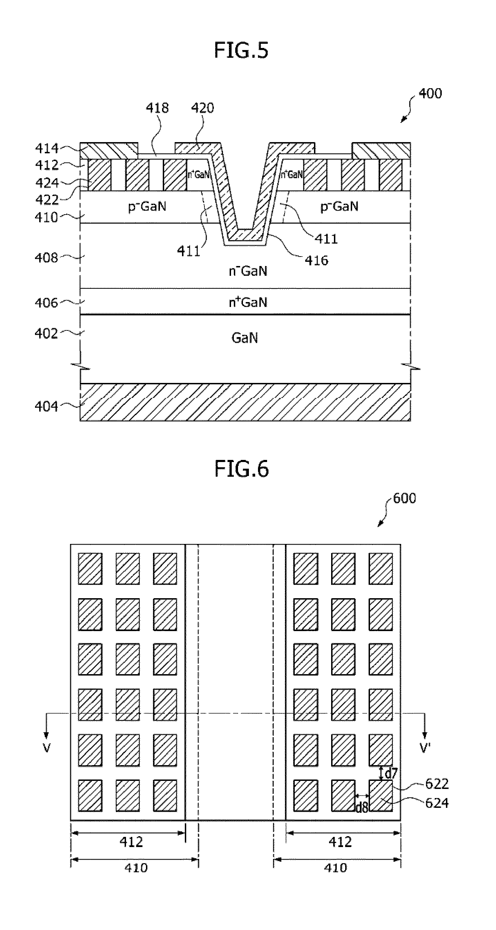

FIG. 4 is a plan view illustrating a vertical transistor 400 having a P-type gallium nitride current barrier layer according to an exemplary embodiments of the present disclosure, and FIG. 5 is a cross-sectional view taken along a line V-V' of FIG. 4. FIG. 4 corresponds to a plan view at a surface level of a donor layer 412 of FIG. 5. Referring to FIGS. 4 and 5, a drain electrode 404 is disposed on a bottom surface of a substrate 402, and a buffer layer 406 is disposed on a top surface of the substrate 402. In one exemplary embodiment, the substrate 402 may be a gallium nitride (GaN) substrate, and the buffer layer 406 may be an N-type GaN layer. A drift layer 408 is disposed on the buffer layer 406. In one exemplary embodiment, the drift layer 408 may be an N-type GaN layer having an impurity concentration which is lower than that of the buffer layer 406. A P-type GaN current barrier layer 410 is disposed on the drift layer 408. In one exemplary embodiment, the P-type GaN current barrier layer 410 may be a GaN layer doped with magnesium ions corresponding to a P-type dopant. A donor layer 412 is disposed on the P-type GaN current barrier layer 410. In one exemplary embodiment, the donor layer 412 may be an N-type GaN layer having an impurity concentration which is higher than that of the drift layer 408.

A trench 416 penetrates the donor layer 412 and the P-type GaN current barrier layer 410 and vertically extends into the drift layer 408. The trench 416 divides the donor layer 412 into two separate portions that extend in one direction to have stripe shapes. Similarly, the trench 416 divides the P-type GaN current barrier layer 410 into two separate portions that extend in the one direction to have stripe shapes. The P-type GaN current barrier layer 410 may act as a channel body layer. Thus, a drain current of the vertical transistor 400 does not flow through a bulk region of the P-type GaN current barrier layer 410. However, the drain current of the vertical transistor 400 may flow only through channel layers 411 formed at sidewall surfaces of the separate P-type GaN current barrier layers 410 which are exposed by the trench 416.

Metal contact plugs 424 vertically penetrate the donor layer 412 to directly contact each of the P-type GaN current barrier layers 410. Each of the metal contact plugs 424 have a circular shape in a plan view, as illustrated in FIG. 4. That is, each of the metal contact plugs 424 fills a cylinder-shaped (circular) hole 422 penetrating the donor layer 412. Each of the metal contact plugs 424 includes a metal material exhibiting an ohmic contact property with respect to the P-type GaN current barrier layer 410. In one exemplary embodiment, distances D5 and D6 between the metal contact plugs 424 are less than or equal to 5 micrometers. Source electrode 414 may be disposed on the metal contact plugs 424 and the donor layer 412. A gate insulation layer 418 is disposed on an inner surface of the trench 416, and a gate electrode 420 is disposed on the gate insulation layer 418.

FIG. 6 is a plan view illustrating a vertical transistor 600 having a P-type gallium nitride current barrier layer according to one exemplary embodiment of the present disclosure. A cross-sectional view taken along a line V-V' of FIG. 6 may be the same as the cross-sectional view of FIG. 5. In FIG. 6, the same reference numerals as used in FIGS. 4 and 5 denote the same elements as set forth with reference to FIGS. 4 and 5. Thus, detailed descriptions of the same elements as set forth with reference to FIGS. 4 and 5 will be omitted hereinafter to avoid a repeated description. Referring to FIG. 6, the vertical transistor 600 according to the present exemplary embodiment is different from the vertical transistor 400 of FIG. 4 in terms of a shape of metal contact plugs 624. Specifically, while each of the metal contact plugs 424 of the vertical transistor 400 has a circular shape in a plan view, each of the metal contact plugs 624 of the vertical transistor 600 has a rectangular shape in a plan view. That is, each of the metal contact plugs 624 fills a tetragon-shaped (rectangular) hole 622 penetrating the donor layer 412. Distances D7 and D8 between the metal contact plugs 624 are less than or equal to 5 micrometers.

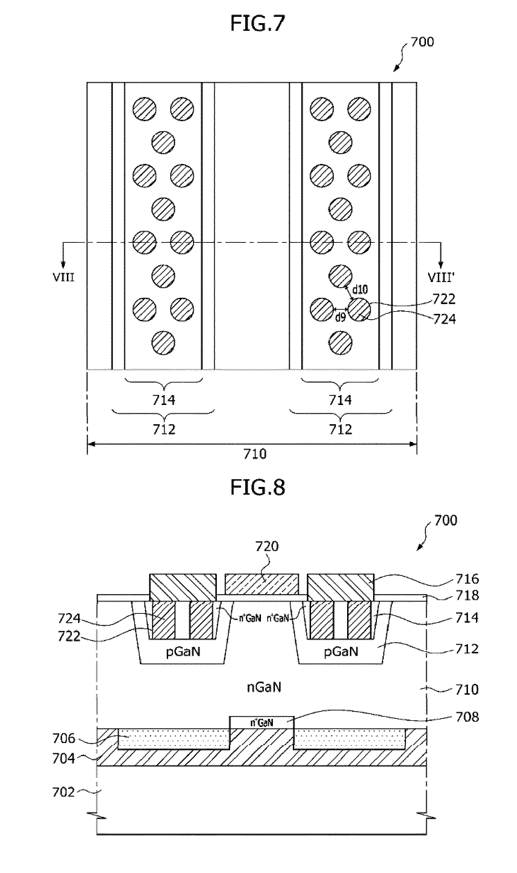

FIG. 7 is a plan view illustrating a vertical transistor 700 having a P-type gallium nitride current barrier layer according to an exemplary embodiment of the present disclosure, and FIG. 8 is a cross-sectional view taken along a line VIII-VIII' of FIG. 7. Referring to FIGS. 7 and 8, a drain electrode 704 is disposed on a substrate 702. In one exemplary embodiment, the substrate 702 may be a support substrate. Current blocking patterns 706 are disposed on portions of the drain electrode 704. A low-resistance pattern 708 is disposed on the drain electrode 704 between the current blocking patterns 706. In one exemplary embodiment, the low-resistance pattern 708 may be an N-type GaN layer. A drift layer 710 is disposed on the current blocking patterns 706 and the low-resistance pattern 708. In one exemplary embodiment, the drift layer 710 may be an N-type GaN layer having an impurity concentration which is lower than that of the low-resistance pattern 708. P-type GaN current barrier layers 712 are disposed in the drift layer 710 and spaced apart from each other. As illustrated in FIG. 7, the P-type GaN current barrier layers 712 extend in one direction to have stripe shapes. Moreover, each of the P-type GaN current barrier layers 712 may have a "U"-shaped cross-section, as illustrated in FIG. 8. A drain current of the vertical transistor 700 does not flow through bulk regions of the P-type GaN current barrier layers 712. However, the drain current of the vertical transistor 700 may flow only through channel layers formed at top surfaces of the P-type GaN current barrier layers 712 that overlap with a gate electrode, as described below.

Donor layers 714 are disposed in respective spaces surrounded by the "U"-shaped current barrier layers 712. In one exemplary embodiment, each of the donor layers 714 may be an N-type GaN layer. As illustrated in FIG. 7, the donor layers 714 extend in the one direction to have stripe shapes. That is, the donor layers 714 are parallel with the P-type GaN current barrier layers 712. Metal contact plugs 724 vertically penetrate the donor layers 714 to directly contact each of the P-type GaN current barrier layers 712. Each of the metal contact plugs 724 have a circular shape in a plan view, as illustrated in FIG. 7. That is, each of the metal contact plugs 724 fill a cylinder-shaped hole 722 penetrating the donor layers 714. Each of the metal contact plugs 724 includes a metal material exhibiting an ohmic contact property with respect to the P-type GaN current barrier layers 712. In one exemplary embodiments, distances D9 and D10 between the metal contact plugs 724 are less than or equal to 5 micrometers. Source electrodes 716 are disposed on the metal contact plugs 724 and the donor layers 714. A gate insulation layer 718 is disposed on a top surface of the drift layer 710 between the P-type GaN current barrier layers 712 and top surfaces of the P-type GaN current barrier layers 712, and a gate electrode 720 is disposed on the gate insulation layer 718.

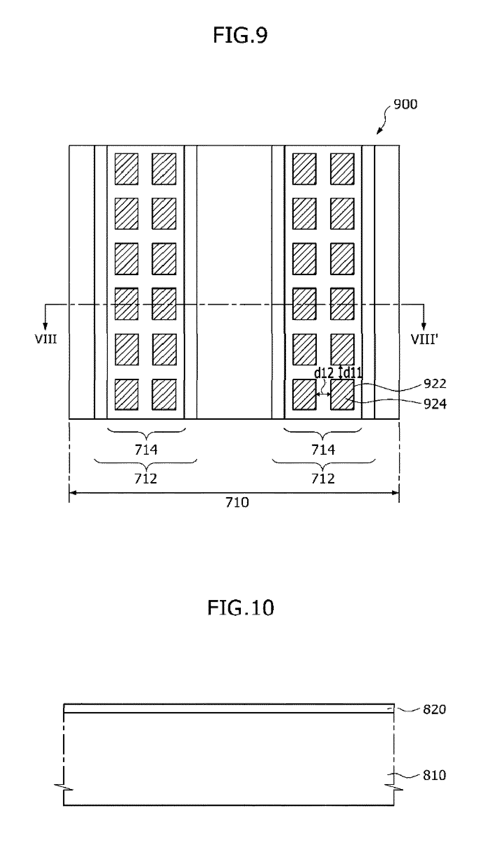

FIG. 9 is a plan view illustrating a vertical transistor 900 having a P-type gallium nitride current barrier layer according to an exemplary embodiment of the present disclosure. A cross-sectional view taken along a line VIII-VIII' of FIG. 9 may be the same as the cross-sectional view of FIG. 8. In FIG. 9, the same reference numerals as used in FIGS. 7 and 8 denote the same elements as set forth with reference to FIGS. 7 and 8. Thus, detailed descriptions of the same elements as set forth with reference to FIGS. 7 and 8 will be omitted hereinafter to avoid a repeated description. Referring to FIG. 9, the vertical transistor 900 according to the present exemplary embodiment is different from the vertical transistor 700 of FIG. 7 in terms of a shape of metal contact plugs 924. Specifically, while each of the metal contact plugs 724 of the vertical transistor 700 has a circular shape in a plan view, each of the metal contact plugs 924 of the vertical transistor 900 has a rectangular shape in a plan view. That is, each of the metal contact plugs 924 fill a tetragon-shaped (rectangular) hole 922 penetrating the donor layers 714 of FIG. 8. Distances D11 and D12 between the metal contact plugs 924 are less than or equal to 5 micrometers.

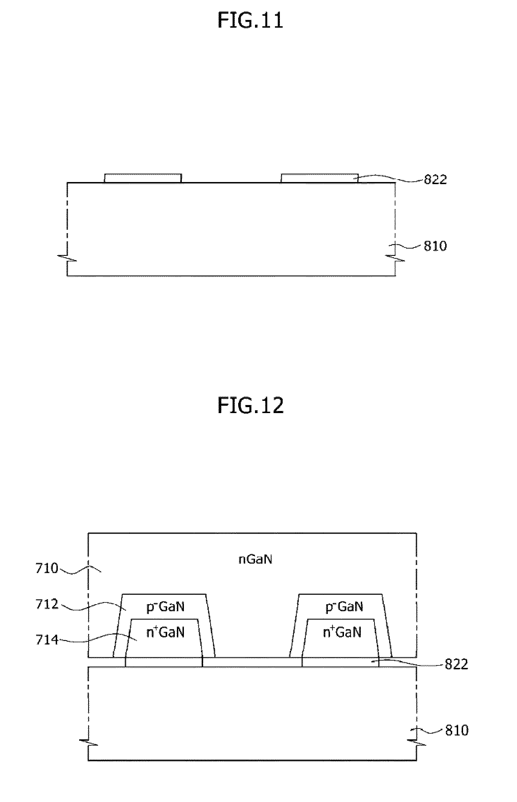

FIGS. 10 to 20 are cross-sectional views illustrating a method of fabricating a vertical transistor having a P-type gallium nitride current barrier layer according to an exemplary embodiment of the present disclosure. Referring to FIG. 10, a semiconductor layer 820 is formed on a first substrate 810. The first substrate 810 may be a growth substrate, for example, a sapphire substrate or a GaN substrate. In the present exemplary embodiment, the semiconductor layer 820 is formed of a GaN layer. Subsequently, the semiconductor layer 820 is patterned to form semiconductor patterns 822 that expose portions of the first substrate 810, as illustrated in FIG. 11. Donor layers 714 are then formed on respective semiconductor patterns 822, as illustrated in FIG. 12. In the present exemplary embodiment, the donor layers 714 may be formed of an N-type GaN layer. P-type GaN current barrier layers 712 are formed on respective donor layers 714. The P-type GaN current barrier layers 712 may be formed by doping a GaN layer with magnesium ions corresponding to a P-type dopant. The P-type GaN current barrier layers 712 are formed to cover sidewalls and top surfaces of the donor layers 714. A drift layer 710 is then formed on the P-type GaN current barrier layers 712. The drift layer 710 may be formed of an N-type GaN layer having an impurity concentration which is lower than that of the donor layers 714.

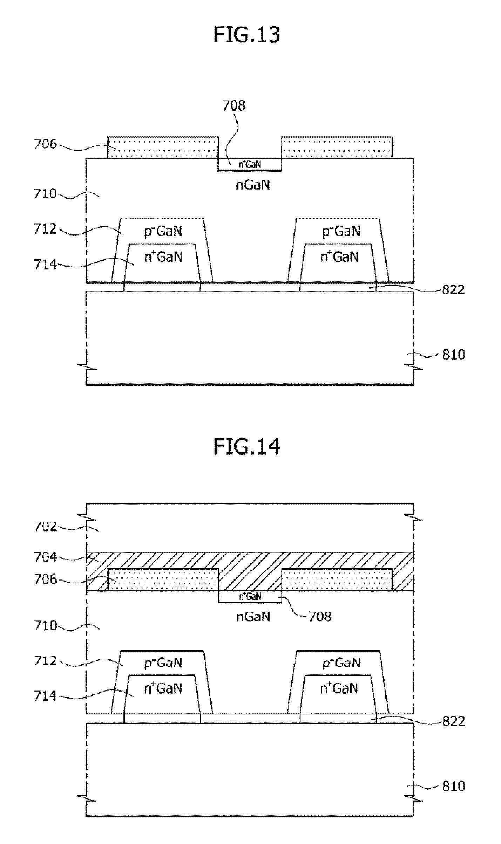

Subsequently, as illustrated in FIG. 13, current blocking patterns 706 are formed on the drift layer 710. In one exemplary embodiment, the current blocking patterns 706 may be formed from a silicon oxide layer. The current blocking patterns 706 are formed to expose a portion of the drift layer 710. A low-resistance pattern 708 is formed on the exposed portion of the drift layer 710. The low-resistance pattern 708 may be formed of an N-type GaN layer having an impurity concentration which is higher than that of the drift layer 710. In one exemplary embodiment, a dry etch process may be applied to the exposed portion of the drift layer 710. In such a case, the dry etch process may be performed using the current blocking patterns 706 as etch masks. As a result, an etch damage layer may be formed in the exposed portion of the drift layer 710 to act as the low-resistance pattern 708.

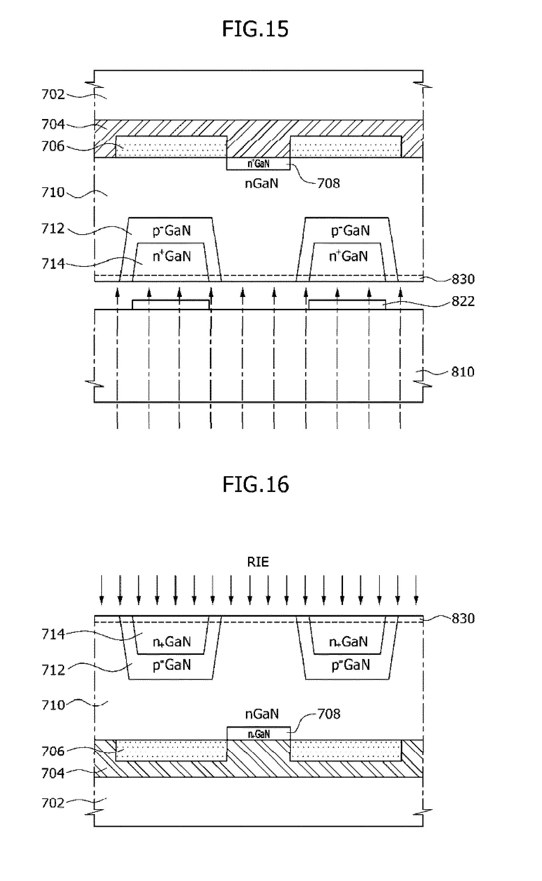

As illustrated in FIG. 14, a drain electrode 704 is formed on the current blocking patterns 706 and the low-resistance pattern 708, and a second substrate 702 is formed on or attached to the drain electrode 704. The second substrate 702 corresponds to a support substrate. A material of the second substrate 702 is not limited to any specific material. Subsequently, as illustrated in FIG. 15, the first substrate 810 and the semiconductor patterns 822 is removed from the drift layer 710. To remove the first substrate 810 and the semiconductor patterns 822, a laser beam is radiated onto the first substrate 810, as denoted by arrows. The laser beam is irradiated with a sufficient energy to penetrate the first substrate 810 and the semiconductor patterns 822. As a result, a damaged layer 830 is formed at an interface between the first substrate 810 and the drift layer 710. The first substrate 810 and the semiconductor patterns 822 are lifted off and detached from the donor layers 714, the P-type GaN current barrier layers 712, and the drift layer 710, at the damaged layer 830. Referring to FIG. 16, a dry etch process is then applied to the damaged layer 830 to remove the damaged layer 830, as denoted by arrows. The dry etch process for removing the damaged layer 830 may be performed using a reactive ion etching (RIE) technique.

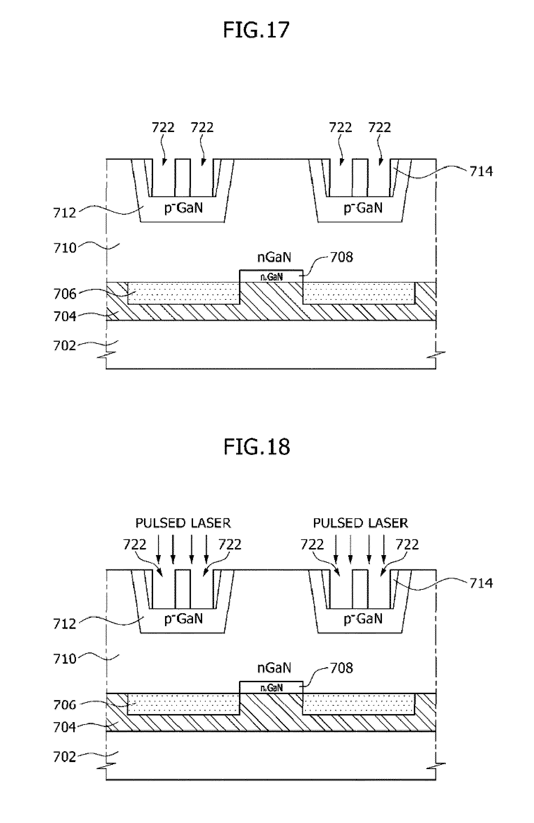

As illustrated in FIG. 17, the donor layers 714 are patterned to form holes 722 exposing portions of the P-type GaN current barrier layers 712. The holes 722 may be formed using a photolithography process and an etch process. Specifically, a resist pattern (not shown) is formed on the drift layer 710 to have openings that expose portions of the donor layers 714. Subsequently, the exposed portions of the donor layers 714 may be etched using the resist pattern as an etch mask to form the holes 722, and the resist pattern may be removed. Each of the holes 722 is formed to have a circular shape in a plan view as illustrated in FIG. 7 or a rectangular shape in a plan view as illustrated in FIG. 9. The holes 722 are formed such that distances between the holes 722 are less than or equal to 5 micrometers.

Referring to FIG. 18, a pulsed laser beam is irradiated onto the P-type GaN current barrier layers 712 through the holes 722. The pulsed laser beam activates the magnesium ions (acting as P-type dopants) in the P-type GaN current barrier layers 712 to remove hydrogen elements combined with the magnesium ions. The pulsed laser process may increase a temperature of metal materials, such as the magnesium, less, as compared with a general annealing processes, and may periodically irradiate the P-type GaN current barrier layers 712 without continuity. Thus, the pulsed laser process may minimize crystalline defects generated in the P-type GaN current barrier layers 712. That is, the pulsed laser process may improve characteristics of the P-type GaN current barrier layers 712 by activating the magnesium ions in the P-type GaN current barrier layers 712 without thermal damage and removing the hydrogen elements combined with the magnesium ions.

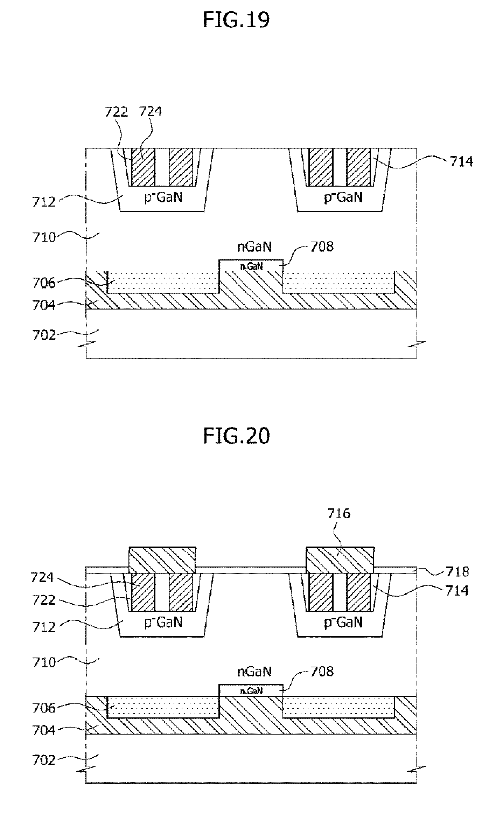

Referring to FIG. 19, the holes 722 are filled with a metal layer to form metal contact plugs 724 in respective ones of the holes 722. The metal contact plugs 724 are formed of a metal material having a good ohmic contact with respect to the P-type GaN current barrier layers 712. Subsequently, as illustrated in FIG. 20, source electrodes 716 are formed on the metal contact plugs 724 and the donor layers 714. A gate insulation layer 718 is formed on top surfaces of the drift layer 710 and the P-type GaN current barrier layers 712. A gate electrode 720 is then formed on the gate insulation layer 718, as illustrated in FIG. 8.

According to the exemplary embodiments described above, a pulsed laser beam is irradiated onto P-type GaN current barrier layers exposed by holes to activate magnesium ions acting as P-type dopants in the P-type GaN current barrier layers, and to remove hydrogen combined with the magnesium ions. The pulsed laser process may increase a temperature of metal elements, such as the magnesium ions, less, as compared with general annealing processes, and may periodically apply a laser beam without continuity. Thus, the pulsed laser process may minimize crystalline defects generated in the P-type GaN current barrier layers. That is, the pulsed laser process may improve characteristics of the P-type GaN current barrier layers by activating the magnesium ions in the P-type GaN current barrier layers without thermal damage and removing the hydrogen combined with the magnesium ions.

It will be apparent to those skilled in the art that various modifications and variation can be made in the present disclosure without departing from the spirit or scope of the disclosure. Thus, it is intended that the present disclosure cover the modifications and variations of this disclosure provided they come within the scope of the appended claims and their equivalents.

## Claims

1. A vertical transistor, comprising:
a drain electrode disposed on a first region of a substrate;
a drift layer disposed on a second region of the substrate that is spaced apart from the first region;
P-type gallium nitride current barrier layers disposed on the drift layer and comprising a current aperture disposed between current barrier layers, the current aperture providing a path through which carriers vertically move;
a channel layer disposed on the drift layer and the P-type gallium nitride current barrier layers, the channel layer comprising a two-dimension electron gas layer adjacent to a top surface thereof;
a semiconductor layer disposed on the channel layer and configured to induce formation of the two-dimension electron gas layer;
metal contact plugs disposed in the channel layer and contacting the current barrier layers;
a source electrode disposed on the contact plugs and the channel layer; and
a gate insulation layer and a gate electrode sequentially disposed on a top surface of the semiconductor layer opposite to the channel layer.

2. The vertical transistor of claim 1, wherein the drift layer comprises N-type gallium nitride.

3. The vertical transistor of claim 1, wherein the channel layer comprises gallium nitride and the semiconductor layer comprises aluminum gallium nitride (AlGaN).

4. The vertical transistor of claim 1, wherein each of the contact plugs has a circular widthwise cross-section in a plan view.

5. The vertical transistor of claim 1, wherein each of the contact plugs has a rectangular widthwise cross-section in a plan view.

6. The vertical transistor of claim 1, wherein a distance between adjacent contact plugs is 5 micrometers or less.

7. A vertical transistor, comprising:
a drift layer disposed on a drain electrode;
a P-type gallium nitride current barrier layer disposed on the drift layer;
a donor layer disposed on the current barrier layer;
metal contact plugs disposed in the donor layer and contacting the current barrier layers;
a source electrode disposed on the metal contact plugs and the donor layer;
a trench disposed in the donor layer, the current barrier layer, and the drift layer; and
a gate insulation layer disposed on an inner surface of the trench, and a gate electrode disposed on the gate insulation layer.

8. The vertical transistor of claim 7, further comprising:
a substrate disposed between the drain electrode and the drift layer; and
a buffer layer disposed between the substrate and the drift layer.

9. The vertical transistor of claim 7, wherein the drift layer comprises N-type gallium nitride and the donor layer comprises N-type gallium nitride having an impurity concentration higher than that of the drift layer.

10. The vertical transistor of claim 7, wherein each of the contact plugs has a circular widthwise cross-section in a plan view.

11. The vertical transistor of claim 7, wherein each of the contact plugs has a rectangular widthwise cross-section in a plan view.

12. The vertical transistor of claim 7, wherein a distance between the contact plugs is 5 micrometers or less.

13. A vertical transistor, comprising:
a drain electrode;
current blocking patterns disposed on the drain electrode and separated by an opening providing a current flow path;
a low-resistance pattern disposed on the drain electrode in the opening;
a drift layer covering the low-resistance pattern and the current blocking patterns;
P-type gallium nitride current barrier layers disposed in the drift layer, each of the current barrier layers comprising a channel region adjacent to a top surface thereof;
donor layers disposed on the current barrier layers;
metal contact plugs disposed in the donor layers and contacting the current barrier layers;
a source electrode disposed on the contact plugs and the donor layers; and
a gate insulation layer disposed on the drift layer between the current barrier layers, and a gate electrode disposed on the gate insulation layer,
wherein the gate insulation layer and the gate electrode extend onto the channel regions of the current barrier layers.

14. The vertical transistor of claim 13, wherein:
the low-resistance pattern comprises N-type gallium nitride;
the drift layer comprises N-type gallium nitride having an impurity concentration lower than that of the low-resistance pattern; and
each of the donor layers comprises N-type gallium nitride having an impurity concentration higher than that of the drift layer.

15. The vertical transistor of claim 13, wherein each of the contact plugs has a circular widthwise cross-section in a plan view.

16. The vertical transistor of claim 13, wherein each of the contact plugs has a rectangular widthwise cross-section in a plan view.

17. The vertical transistor of claim 13, wherein a distance between the contact plugs is 5 micrometers or less.

18. A method of fabricating a vertical transistor, the method comprising:
forming a drain electrode, a drift layer on the drain electrode, P-type gallium nitride current barrier layers in the drift layer, and donor layers on the current barrier layers;
patterning the donor layers to form holes exposing portions of the current barrier layers; and
removing hydrogen from the current barrier layers after forming the holes.

19. The method of claim 18, wherein each of the holes comprises a circular widthwise cross-section in a plan view.

20. The method of claim 18, wherein each of the holes comprises a rectangular widthwise cross-section in a plan view.

21. The method of claim 18, wherein removing the hydrogen elements in the current barrier layers comprises radiating a pulsed laser beam onto the current barrier layers through the holes.

22. The method of claim 18, further comprising filing the holes with a metal.
